# EUROPEAN PATENT SPECIFICATION

(11) **EP 1 936 799 B1**
(45) Date of publication and mention of the grant of the patent: **01.07.2009**
(21) Application number: 06425481.6
(22) Date of filing: 11.07.2006
(51) Int. Cl.: H03F 1/32

(54) **Parallel phase and amplitude analog predistorsion linearizer with fixed in advance intermodulation power and gain stabilization**
Analoger paralleler Phasen- und Amplituden-Vorverzerrungslinearisierer mit vorbestimmter Intermodulationsleistung und Stabilisierung der Verstärkung
Linéariseur à predistorsion analogique de phase et d'amplitude en parallèle avec puissance d'intermodulation et stabilisation du gain fixées en avance

(43) Date of publication of application: 25.06.2008
(73) Proprietor: Nokia Siemens Networks S.p.A., 20060 Cassina de'Pecchi (MI) (IT)
(72) Inventor: Fusi, Simone, 21042 Caronno Pertusella (VA) (IT)
(74) Representative: Fischer, Michael

(56) References cited:
- EP-A- 1 592 127
- WO-A-02/37669
- WO-A-94/09574
- US-A- 5 903 854
- MIN-GUN KIM ET AL: "An FET-Level Linearization Method Using a Predistortion Branch FET" IEEE MICROWAVE AND GUIDED WAVE LETTERS, IEEE INC, NEW YORK, US, vol. 9, no. 6, June 1999 (1999-06), XP011035451 ISSN: 1051-8207

## Description

### FIELD OF THE INVENTION

The present invention relates to the field of linear amplification of signals, and more precisely to a parallel phase and amplitude analog predistortion linearizer with fixed in advance intermodulation power and gain stabilization.

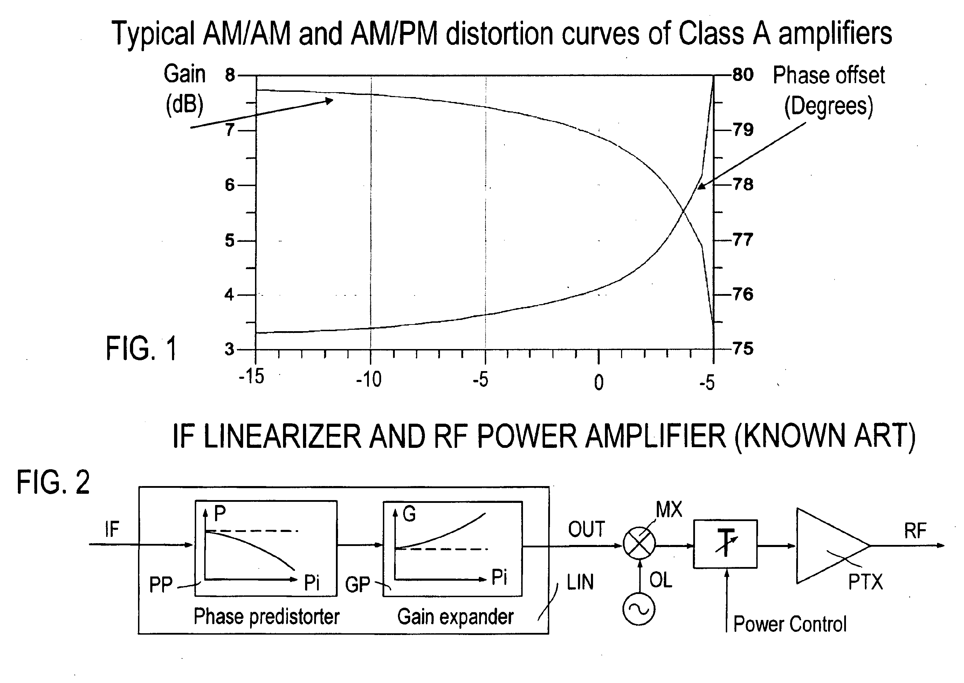

A predistortion linearizer is a device aimed to correct the defects of a final power amplifier in its task of reproducing the exact shape of the original signal but at higher power level, this means reproducing both the exact amplitude and phase offset among the various spectral components of the original signal. As known, power amplifiers are devices intrinsically non linear at the highest values of amplification so that AM-AM and AM-PM distortions are unavoidably generated. Typical gain and phase response curves for a Class A microwave power amplifier as a function of the input power are reproduced in **fig.1****.** Gain is a significant parameter for testing the linearity of an amplifier: as more it remains constant varying the input power as the amplifier behaves linearly. The gain of the active device is subject to saturation on the highest input power levels starting to decrease fast in fig.1, while in correspondence the phase-offset curve undergoes a faster increase.

Linear amplification is mandatory in those professional applications characterized by high PMPR (peak-to-mean-envelope-power ratio) e.g.: M-QAM, OFDM, MC-DDMA, DAB, DMT, etc. which require a wide linear region of the amplifier in order to avoid distortions of the signal waveform on the peaks. The amount (dB) by which the average output power is reduced from the saturation power in order to preserve the linearity is commonly named OBO (output backoff). Large OBOs due to high PMPRs clearly demonstrates inefficient usage of the available output power (if not otherwise provided). A predistortion linearizer device extends the linear dynamic range of the device to linearize (DTL), reducing the OBO consequently. As known, in order to achieve this result a predistortion linearizer is set to obtain opposite distortion behaviour compared to the DTL. Without limitation, the latter is considered a power FET with known distortion behaviour consisting of compression of the gain and expansion of the input-output phase at the highest power levels of the output signal (and hence of the input signal). As a consequence, the amplitude predistorter expands the gain to annul the effect of gain compression. Considering that the predistortion output signal (with reference to the IF embodiment of **fig.2**) can be converted by a mixer pumped by an OL frequency either higher or lower than the RF carrier, so that the phase of the predistortion signal is either maintained or inverted, the phase predistorter shall operate in order to either compress or expand the phase to annul the effect of phase expansion. Other types of active devices (for example TWTs) have different phase distortion behaviour with respect to the power transistors, but also in this case the phase distortion can be cancelled by a linearizer able to introduce in advance phase variations with opposite sign with respect to the ones introduced by the used active device. The effect of amplitude and phase distortions on the output signal can be checked by the spectral analysis of the in-band intermodulation products: two-tones test is currently used at the purpose.

Without limitation, some exemplary embodiments of the invention will be described for digital radio applications preferably, such as radio links adopting various M-QAM schemes with increasing complexity as the transport capacity of the link increases (higher M for higher spectral efficiency). This restriction is only due to the specific field-of-interest of the Applicant and shall not be considered as a bar for other types of application of the invention every time that high fidelity amplification is needed. Many technical sectors may be concerned with this requirement, because an amplification stage is almost always necessary at the output of the various transducers of physical into electrical signals (e.g.: pressure, velocity, acceleration, light, strengths, etc.). Sound amplification for either live music or recorded reproduction is a clear example. It is in fact well-known that an audio amplifier distorts at the highest volumes, so any solution able to avoid this drawback is desirable. Whether a signal need not to be transmitted, also modulation of a carrier with that signal is generally unnecessary, still remaining the requirement of amplify the signal linearly; with that the present invention also applies to baseband signals although from now onward only modulated carriers will be considered.

M-QAM modulations are described by constellations of symbols representing all possible combinations at a symbol time of the module and the phase of a modulation vector. M-QAM are preferred for their good spectral efficiency. Achieving the maximum linearity of the RF finals is a must for QAM, thus it is subject to international standards (i.e. ETSI) introducing mask restrictions for the out-of-band transmitted power and the BER at the receiver. Accordingly, power amplifiers must have better amplitude and phase linearity than those for use with constant envelope modulations at parity of output power, such as CPM and the like even used in digital radio. This also implies greater power consumption for QAM due to the need of adopting less efficient class A or AB bias than the usual class C only suitable for constant envelope. For the above reasons, also considering the increased complexity of the bias circuits and better precision of the active devices, linear amplifiers are generally costly so that an efficient use of them is felt.

### BACKGROUND ART

The efficiency of linear amplifiers can be improved by the application of known linearization methods classifiable as: feed forward, digital predistortion with or without feedback, or analogue RF signal predistortion. Analog predistortion offers several advantages in comparison to the other methods due to circuital simplicity and low power consumption, but it can have many disadvantages. An attempt to overcome these disadvantages is disclosed the European patent application EP 1592127 A1 (Ref.[1]) in the name of the same Applicant. This document discloses an analog predistortion linearizer to be connected upstream a power amplifier subject to gain compression and phase distortion at high power levels of the output signal, including a phase predistorter and an amplitude predistorter controlled so as to introduce phase and amplitude predistortions at higher power levels of the input signal with opposite directions with respect to the ones introduced by the power amplifier:
- the phase predistorter includes first setting means arranged to set a fixed value of maximum phase predistortion on the signal forwarded to the amplitude predistorter;
- the amplitude predistorter includes second setting means arranged to set a fixed value of maximum amplitude predistortion on the signal forwarded to the power amplifier (PTX);
- both the first and second setting means are configured so as to derive their setting from a maximum fixed-a-priori power level of the in-band intermodulation products introduced by both the phase and amplitude predistorters.

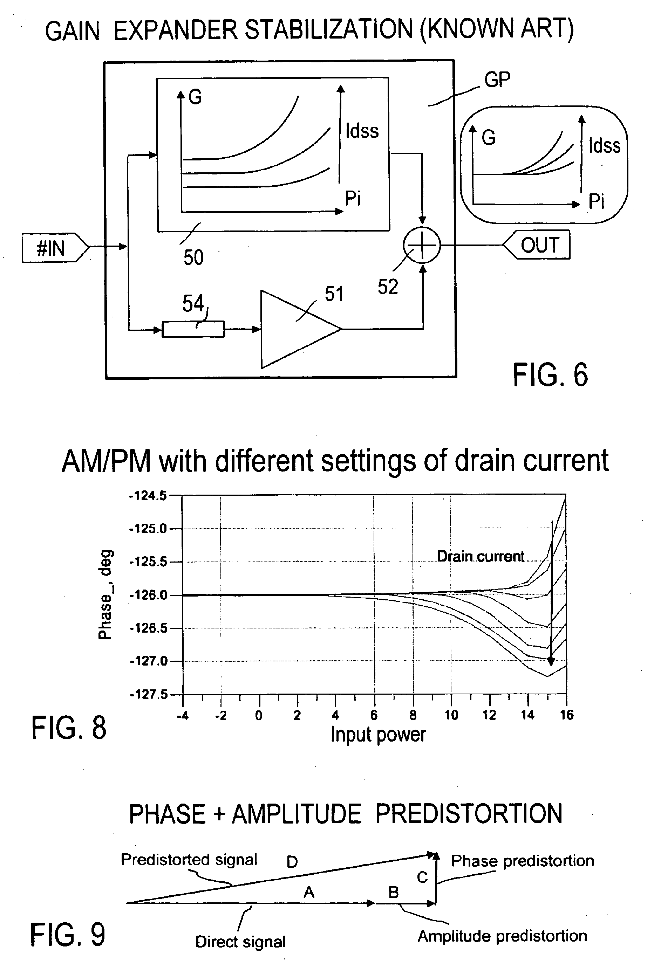

The analog predistortion linearizer of Ref.[1] constitutes the nearest prior art for the present invention and will be discussed with reference to the following **Figures 2** to **6**. With reference to **fig.2**, we see an RF transmission chain including an analog linearizer LIN (Ref.[1]) which accepts a modulated intermediate frequency signal IF and outputs a phase-amplitude predistorted signal OUT directed to a mixer MX pumped by a local oscillator signal OL to translate the predistorted signal at RF. The predistorted RF signal reaches the input of a variable attenuator T upstream an RF power amplifier PTX. The variable attenuator T is controlled by a feedback power control signal in order to set a constant average power level at the output of PTX. The linearizer LIN includes a stabilized gain expander GP cascaded to a phase predistorter PP. A typical predistortion curve of the phase P and expansion curve of the gain G are shown in correspondence of blocks PP and GP, respectively. As said in Ref.[1], and will be proved later with reference to **figures 8** and **9**, the intermodulation products due to the phase distortion introduced by the cascaded amplitude predistorter is 20 dB less than the contribute of the amplitude distortion and the independence of the amplitude from the phase distortion is considered; in other words they are orthogonal, so that the corresponding in-band intermodulation products sum up vectorially to obtain the constant power distortion used to correct the nonlinear behaviour of the power amplifier PTX. The linearizer LIN is put far away from the power amplifier PTX and it is inexpensive because it works at low frequency and a constant signal power.

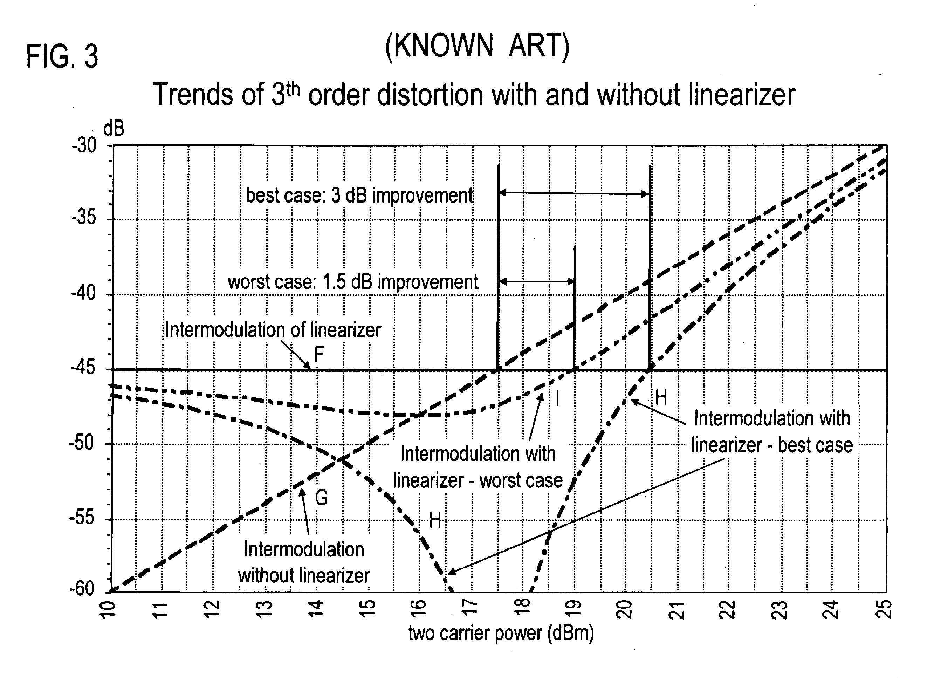

**Fig.3** shows four curves indicated as F, G, H, and I in Ref.[1]. The ordinate represents the in-band intermodulation product level at the output of (in the order): the linearizer LIN; the non-linearized power amplifier; the linearized power amplifier PTX best case; and the linearized power amplifier PTX worst case. With reference to **Fig.3**, on the abscissa from 10 to 25 dBm power range of a two-carrier test signal is reported, on the ordinate the curve F of the linearizer LIN is set to a constant value of -45 dB corresponding to the target distortion which is subtracted at the output of the power amplifier PTX. It can be noticed that for low output power levels the intermodulation products on the curves G, H, I are always less than the value set on the curve F of the linearizer. Besides, the output power for which the best case curve H of the linearized device is below the curve F of the linearizer increases of 3 dB in comparison with the curve G of a non linearized device. The same considerations applied to the worst case curve J of the linearized device show an increase of only 1.5 dB. In conclusion, according to the linearization method of the invention, once maximum acceptable intermodulation products level is defined, it's possible to set the linearizer at this level to obtain 1.5 to 3 dB power gain of the linearized device, automatically.

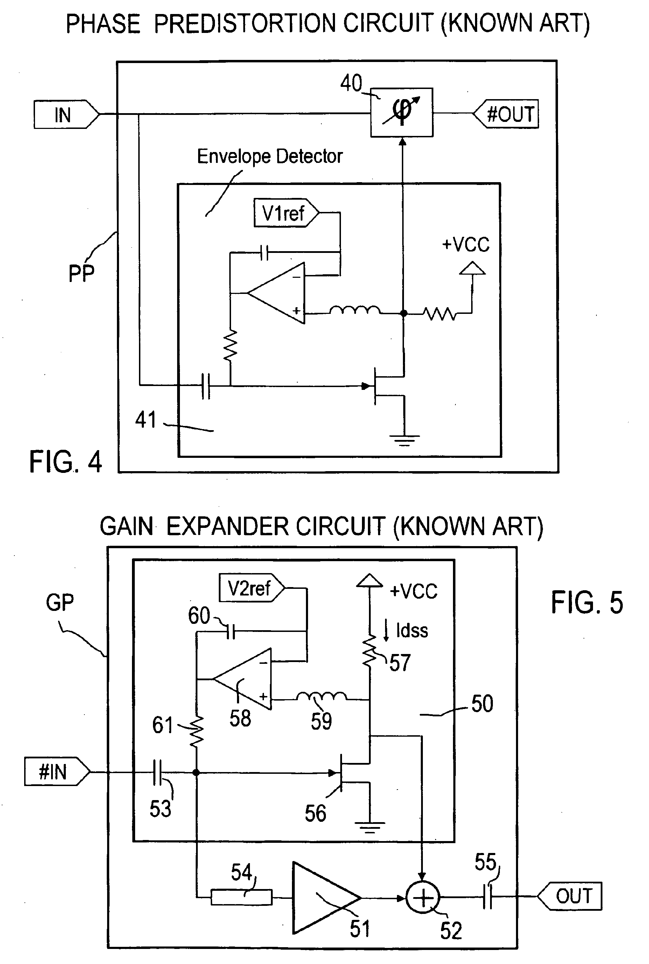

According to Ref.[1], the circuital implementation of the phase predistorter PP is represented in **fig.4**. Circuit PP includes a phase shifter 40 controlled by an envelope detector 41. The input signal IN reaches the input of the two blocks 40 and 41; the phase predistorted signal #OUT is present at the output of block 40. The envelope detector 41 is the same as a functional block 50 including a FET, an operational amplifier, and a stable voltage reference V1 ref, well detailed in the next figure. The phase shifter 40 includes a varactor (phase modulator) controlled by a baseband voltage present on the drain of the FET.

According to Ref.[1], the circuital implementation of the stabilized gain expander GP is represented in **fig.5**. Circuit GP includes a gain expander 50, a wideband amplifier 51, an analog adder 52, and a delay line 54. The input signal #IN is applied through a capacitor 53 both to the input of gain expander 50 and the delay line 54 inserted on the path towards the input of amplifier 51. The two inputs of analog adder 52 are respectively connected to the output of the amplifier 51 and through a capacitor 55 to the output of block 50. The amplitude predistorted signal OUT is taken at the output of adder 52. The gain expander 50 is a functional block mostly derived from a previous European patent EP 0451909 B1 granted in the name of the same Applicant (Ref.[2]) since from 1991. Block 50 includes a FET 56 in common source configuration by means of a polarization network including: a resistance 57 on the drain path towards +VCC, a differential integrator placed in a feedback path between the drain and gate of FET 56, and an inductor 59 acting as RF block towards a first input of the differential integrator. The latter includes an operational amplifier 58 with a stable voltage reference V2ref on the other input, a feedback capacitor 60, and an output resistance 61 connected to the gate of FET 56. The differential integrator is slow enough to be insensitive to the modulation but only sensitive to the average bias current Idss of FET 56. The biasing drain current Idss through the resistor 57 is determined by the feedback action of the operational amplifier 58 which controls the gate of FET 56 in order to set a constant potential difference |VCC - V1ref| across the resistor 57 and hence a constant current Idss = |VCC - V1ref| /R57. The bias current Idss keeps the FET 56 subpolarized in the pinch-off region, so that an increase of the input signal #IN causes a gain expansion of FET 56 by effect of autopolarization. Considering that the power level of the intermodulation products at the output of FET 56 is only function of both the set current Idss and the power of input signal IF, it results that said power level is independent of temperature, pinch-off voltage and Idss spreading.

The former invention disclosed in Ref.[2] was not involved to keep the current Idss constant, as a consequence the use of a feedback differential integrator of Ref.[1] was not considered at all inside block 50 and some drawbacks due to thermal derive and aging were affecting the device. Furthermore, with reference to the two set of curves visible in **fig.6**, the gain expander 50 if considered alone would be subject to a constant initial gain depending on the Idss value actually set, making the amplitude linearizer strictly depending on the particular application, contrarily to the ideal behaviour foreseen for the OUT signal at the output of analog adder 52. The amplifier 51 cascaded to the delay line 54 adds up a direct signal to the predistorted one in order to stabilize the initial gain, trading of with degree of amplitude predistortion.

As said with reference to **fig.3****,** the analog predistortion linearizer of Ref.[1] cancels a fixed power level of the in-band intermodulation products, not necessarily corresponding to the highest power of the interference: if the power level of the intermodulation products of the DTU is fortuitously the same of the one introduced for the aim of linearization, a total cancellation is obtained, if the level is different there will be a partial but effective cancellation. A satisfactorily degree of cancellation is enough (for example -45 dB power level). The output power of the linearized device can be increased of 3 dB with respect to the absence of linearization in the best case, and 1.5 in the worst case. The price paid in term of leaving some possible distortion uncancelled is largely repaid by the absence of any gender of tuning to adapt to the change of physical parameters, and the additional fact to leave the designer unaware of the type of power transistor used in the amplifier and of the allocation of the amplifier. As a consequence of the pseudo-orthogonal amplitude and phase distortions, it might be possible cut out preventively at the linearizer the weights of the due type of distortions which best fit to the distortion signature of the power amplifier known in advance, e.g.: 70% amplitude distortion and 30% phase distortion. This way of operating allows almost total cancellation of the output distortion until the desired fixed value is reached, matching the 3 dB best case.

### TECHNICAL PROBLEM TO BE SOLVED BY THE INVENTION

Despite the many advantages of the analog predistortion linearized of Ref.[1], some other improvements can be introduced aimed to eliminate the residual drawbacks. For example, using a varactor controlled by an envelope detector as analog phase predistorter a matching network including a cumbersome delay line is needed for recovering the delay introduced on either one or the other signal path because of the differences of the two circuital branches. Large phase variations from the varicap diodes of the varactor request some cascaded stages adapted to each other like a bandpass filter. The greater the number of stages the greater the delay of the variable phase shifter and the operating band of the linearizer is reduced consequently.
An alternative configuration of the predistortion linearizer makes use of in-phase and in-quadrature mixers (either diodes or FETs) jointly controlled by the detected envelope of the input signal. Each mixer multiplies the input signal by the voltage envelope of the input signal, obtaining an amplitude modulated output signal by the envelope itself. The two amplitude modulated signal are summed up, and the sign inverted, for obtaining a predistorted signal with impressed simultaneous amplitude and phase predistortion. Although the mixer are intrinsically wideband devices able to introduce large phase variations, the following questions arise:
- The envelope signal shall be amplified.
- A delay equalisation is needed along the envelope signal path for compensating the dominant delay along the two mixers branches.
- It is apparently unknown in the art how the maximum power level of the in-band intermodulation products generated by the two mixers can be fixed in advance.
- A mixer, especially at RF frequency, is a complicated network generally including four diodes (quad) and their coupling lines in balanced or doubly balanced configuration.

In conclusion, a mixer-based analog predistortion linearizer is costly, does not allow remarkable reductions on the substrate area, and leaves the question raised at third point substantially unresolved.

### OBJECTS OF THE INVENTION

The main object of the present invention is that to simplify the design of the analog predistorter linearizers with respect to the designs of the prior art, getting the new design rid of restrictions in the operating band, large occupancy on the substrate area, production costs, and unresolved problems to achieve the advantages of having a constant degree of compensation fixed in advance.

### SUMMARY AND ADVANTAGES OF THE INVENTION

The invention achieves said objects by providing an analog predistortion linearizer to be connected upstream from a power amplifier subject to AM/AM and AM/PM distortions at high power levels of the input signal, comprising amplitude and phase predistortion means arranged so as to impress amplitude and phase distortions on the input signal opposed to the corresponding amplitude and phase distortions introduced by said power amplifier, including:
- a first FET subpolarized near pinch-off for amplifying the input signal with variable gain obtaining a first amplitude predistorted signal for compensating said AM/AM distortion;
- first biasing means of said first FET arranged in feedback to set a first constant average drain current in correspondence of which a first predetermined power level of the in-band intermodulation products is generated;
- a second FET subpolarized near pinch-off for amplifying the input signal with variable gain obtaining a second amplitude predistorted signal for compensating said AM/PM distortion;
- second biasing means of said second FET arranged in feedback to set a second constant average drain current in correspondence of which a second predetermined power level of the in-band intermodulation products is generated;
- linear power amplifying means of the input signal;
- coupling means arranged for coupling the input signal in phase to both said first FET and said linear power amplifying means, and 90° out of phase to said second FET;
- analog adder means arranged for summing up said first and second amplitude predistorted signals and said linearly amplified input signal, obtaining the desired amplitude and phase predistortion signal.

According to the invention, the main drawbacks of the known art are eliminated by the new parallel architecture still employing the gain-stabilized FET subpolarized near pinch-off as main building block but in a different architecture.

GaAsFETs suitable for microwaves are used also in case the linearizer is realized at intermediate frequency; being the cut-off frequency of GaAsFET much higher than the IF frequency, the parasitic effects are reduced and the bandwidth increased consequently.

In respect of EP 1592127 A1 the upstream varactor controlled by an envelope detector with gain expansion plus a cascaded amplifier with gain expansion, is replaced by two amplifiers with gain expansion along two signal paths (branches) in quadrature to each other terminating with an analog adder carrying out both phase and amplitude predistortion simultaneously. A significant space saving on the substrate and more bandwidth is intrinsically obtained from the elimination of the varactor and additional circuit for delay equalization; as previously said the bandwidth of the varactor is inversely proportional to the attainable phase variation. The advantage to achieve gain stabilization and no-tuning linearization is maintained.

Concerning the mentioned hypothesis of using quadrature mixers and a cascaded adder to build up the predistortion linearizer, whose implementation with fixed intermodulation is yet to be proved, the advantages of the invention in saving space on the substrate and not to tune the linearization are maintained, jointly to a circuital simplification and significant cost saving. Besides, the I-Q scheme of the invention is conceptually different from an I-Q scheme employing mixers, either implemented using diodes or FETs. In fact, the devices used in the present invention are active (not passive as diodes) and provide in-band intermodulation products without needing multiplication by an envelope signal but only during the amplification of the input signal.

The predistortion linearizer of the invention can be put at RF or IF indifferently; nevertheless, considering that the RF amplifier is subject to power control and the envelope of the output signal is variable consequently, it could be preferable placing the predistortion linearizer at the IF section characterized by a constant signal power. This allows a circuital simplification and saving costs. Profitably, the predistortion linearizer at the IF section can be put far away from the power amplifier; for example, the overall transmission chain can be split into an IDU-ODU configuration.

### BRIEF DESCRIPTION OF THE DRAWINGS

The features of the present invention which are considered to be novel are set forth with particularity in the appended claims. The invention and its advantages may be understood with reference to the following detailed description of an embodiment thereof taken in conjunction with the accompanying drawings given for purely non-limiting explanatory purposes and wherein:
- **fig.1****,** already described, shows typical gain and phase distortion curves versus the input power for Class A amplifiers;
- **fig.2****,** already described, shows a tandem configuration of phase and amplitude IF predistortion linearizers of the known art;
- **fig.3****,** already described, shows some logarithmic power curves of 3rd order intermodulation products versus the input power of two-carrier test signal, measured at the output of a Class A power amplifier cascaded to an amplitude predistortion linearizer of the known art with fixed in advance maximum predistortion;
- **fig.4****,** already described, shows a phase predistortion circuit used in the phase predistortion linearizer of fig.2;
- **fig.5****,** already described, shows a gain expander circuit used in the amplitude predistortion linearizer of fig.2;
- **fig.6****,** already described, shows a stabilization circuit for the gain expander used in the amplitude predistortion linearizer of fig.2;
- **fig.7** shows the circuital representation of amplitude and phase predistortion linearizer of the present invention;
- **figures 7A, 7B,** and **7C** show three identically configured stages belonging to the predistortion linearizer of fig.7;
- **fig.8** shows some AM/PM curves of the circuit of fig.6 with different setting of the drain current;
- **fig.9** shows a vectorial representation of the stabilized amplitude and phase predistortion contributes achievable by the circuitry of fig.7;

### DETAILED DESCRIPTION OF AN EMBODIMENT OF THE INVENTION

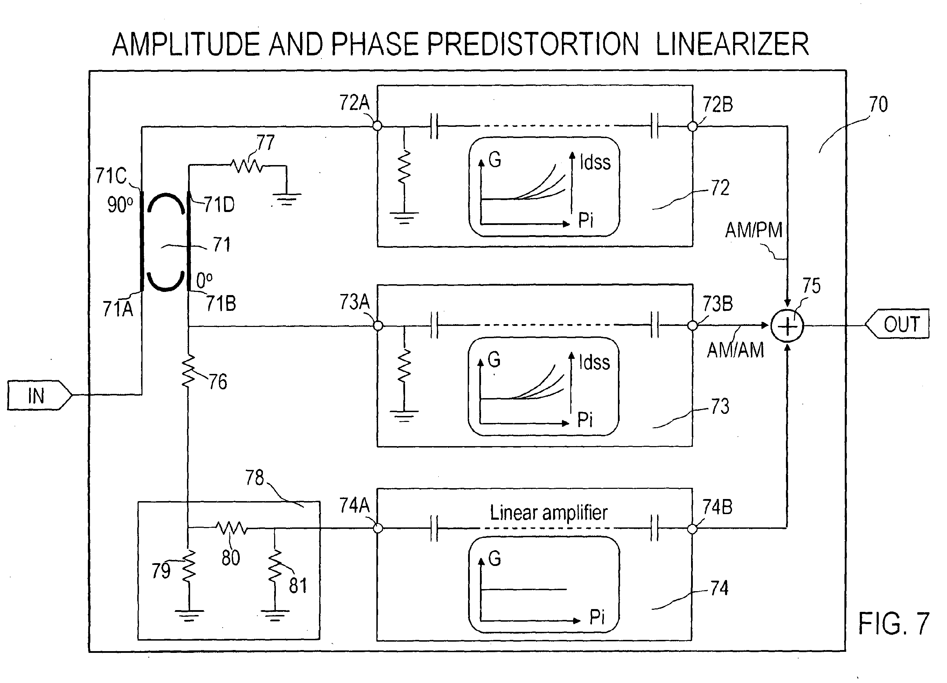

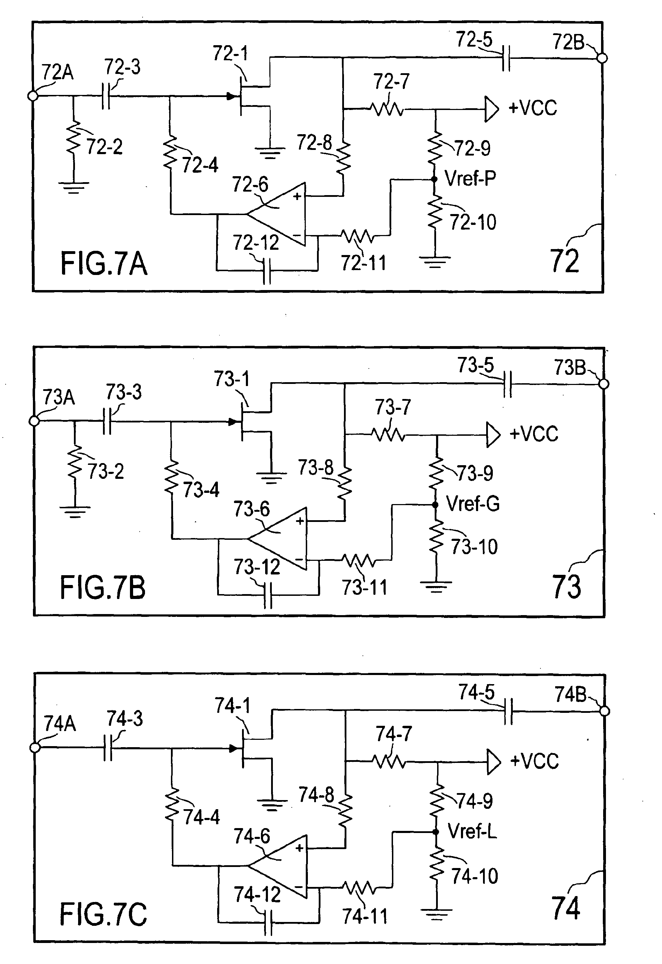

With reference to **fig.7****,** we see a predistortion linearizer 70 including a 90° phase shifter 71, three active amplifier stages 72, 73, 74, an analog adder 75, two resistors 76 and 77 connected to the phase shifter 71, and a resistive π-cell attenuator 78 including three resistances 79, 80, 81. The phase shifter 71 has a first port 71A in correspondence of the input port IN of the predistortion linearizer 70, a second port 71 B for an output signal coupled in-phase to the input signal entering the port 71A, a third port 71C for an output signal coupled 90° out-of-phase to the input signal entering the port 71A, and a fourth port 71 D coupled to the adapted load represented by the grounded resistor 77. Port 71C is coupled to the input 72A of the amplifier stage 72 whose output 72B is connected to a first input of adder 75. Port 71 B is coupled to a first end of the resistor 76 and the input 73A of the amplifier stage 73 whose output 73B is connected to a second input of adder 75. The other end of resistor 76 is coupled to the resistive attenuator 78 and the attenuated signal is coupled to the input 74A of the amplifier stage 74 whose output 74B is connected to the third input of adder 75. The summation signal at the output of adder 75 is coupled to the output OUT of the predistortion linearizer 70. The description of the amplifier stages 72, 73, and 74 is postponed to the next figures.

Considering without limitation a predistortion linearizer operating in the microwaves, the 90°phase shifter 71 is obtained through a hybrid coupler, so to have the maximum working bandwidth; to avoid the use of the coupler but at the cost of smaller bandwidth, the splitting of the signal can be obtained with a Wilkinson divider and the 90°phase shift with a delay line. Input ports 72A, 73A, and 74A are adapted to the impedance of the coupling lines and are capacitively coupled to the remaining circuitry. In accordance with previously said on the orthogonal property of phase in respect of amplitude intermodulation products, the amplifier stage 72 placed on the in-quadrature signal path accounts for phase predistortion, while the amplifier stage 73 placed on the in-phase signal path accounts for amplitude predistortion. The third amplifier stage 74 is placed on another direct signal path and does not introduce predistortion but promotes gain stabilization independently of the biasing current selected in the other stages. The attenuator 78, varying the gain of the direct signal path, trades off between the gain stabilization of amplifier stages 72 and 73 and the maximum possible equalization. Output ports 72B, 73B, and 74B are capacitively coupled to the inputs of the analog adder 75 so to have the maximum working bandwidth. The three-input analog adder 75 is implemented by means of coupled lines.

Figures 7A, 7B, and 7C show a same circuital embodiment valid for the active stages 72, 73, and 74, with some variations only in the resistor values of the various stages to account for the gain expansion in stages 72 and 73 (near pinch-off) and linear amplification in stage 74 (class A amplifier). **Table 1** at the end of the description is the component data sheet. The three stages 72, 73, and 74 includes a respective GaAsFET 72-1, 73-1, and 74-1. With reference to fig.7A, stage 72 includes a FET 72-1 having the gate connected to an input RC network, the source connected to ground in common source configuration, and the drain connected to an active biasing network dimensioned so as to generate a feedback gate voltage suitable to stabilize the drain current to a fixed value. The input RC network includes a resistor 72-2 across the input port 72A having one end connected to a capacitor 72-3 and the other end to ground. The resistor 72-2 is matched to the impedance of the coupling line coming from hybrid 71. The other end of capacitor 72-3 is connected to the gate of FET 72-1, similarly a capacitor 72-3 couples the output signal present on the drain of FET 72-1 to the output port 72B. The drain of FET 72-1 is connected to the biasing voltage +VCC through a resistor 72-7. The +VCC terminal is further connected to a resistive voltage divider constituted by the series of two resistors 72-9 and 72-10 connected to ground. By effect of the partition a voltage reference Vref-P is set at the central point of the series. Voltage Vref-P is applied to one end of a resistor 72-11 connected to the input (-) of an operational amplifier 72-6 in differential integral configuration trough a capacitor 72-12 placed between the output and the input (-). The other input (+) of the operational amplifier 72-6 is connected to the drain of FET 72-1 through a resistor 72-8. The output of 72-6 is connected to the gate of FET 72-1 through a resistor 72-4. In operation, the differential integrator 72-6 is slow enough to be insensitive to the modulation but only sensitive to the average drain current through the **FET 72-1.** The average drain current is the biasing drain current Idss through the resistor 72-7 determined by the feedback action of the operational amplifier 72-6 which controls the gate of FET 72-1 in order to set a potential difference |VCC - Vref-P| across the resistor 72-7 constant on the average, and hence an Idss drain current. The bias current Idss keeps the FET 72-1 subpolarized in the pinch-off region, so that an increase of the input signal causes a gain expansion of FET 72-1 by effect of autopolarization. The power level of the intermodulation products at the output of FET 72-1 is only function of the set current Idss and the power of input signal IF, so that the maximum intermodulation is limited by the Idss value.

A detailed discussion on gain expansion theory is given in the article of A. Abbiati, C. Buoli, L. A. Cervi, titled: "Quasi pinch-off GaAsFET linearizer for microwave SSPA", EuMC 1991, pp 1147-1452.

The previous description of phase predistortion stage 72 is also valid for amplitude predistortion stage 73 in **fig.7B**. The design shall take into account that the ratio between the gain expansion of the two stages 72 and 73 directly depends on the ratio between the two drain currents (Idss₇₂/ Idss₇₃) and in the same manner the ratio between phase and amplitude predistortions.

With reference to **fig.7C**, differently, from stages 72 and 73, the polarization network of stage 74 is dimensioned to stabilize Class A working point of FET 74-1 for linear amplification without distortion. Being the circuital embodiment of stage 74 the same as stages 72 and 73, the signal delay across stage 74 is equalized to the delays across the other stages, automatically.

A family of AM/PM distortion curves for the single gain expansion stage, either 72 or 73, with drain current as parameter is given in **fig.8**. Less than 3° phase offset spans the maximum variation of the drain current, to say, the included FET has a limited AM/PM residual. The phase distortion is calculated to be 20 dB less than the amplitude distortion set on the device; this authorize to use the two gain expander stages 72 and 73 to set the phase and amplitude predistortions independently to each other (in other words they are orthogonal). The linear amplifier stage 74 stabilizes the gain of both stages 72 and 73. The family curves of **fig.8** is obtained from the stabilized stage under investigation.

The way of how the phase and amplitude predistortions sum up vectorially to the direct signal to obtain the overall predistorted signal at the output of analog adder 75 (**fig.7**) is depicted in **fig.9**. With reference to **fig.9** and **fig.7**, we see two orthogonal vectors B, C respectively associated to the amplitude and the phase predistortion impressed by the stages 73 and 72, respectively. Assuming the most general case of totally unknown behaviour at the linearizer 70 about the intermodulation signature of the final power amplifier, equal contributions is assumed. In this case vectors B and C have equal module representing the individual contributions to the overall predistortion. Vector A parallel to vector B represents the direct signal at the output of linear stage 74. This vector has a module greater than the module (-45 dB) of vectors B and C because the predistortion only account for a small percentage of the undistorted signal power. The summation vector D = A + B + C at the output of analog adder 75 represents the predistorted signal forwarded by the linearizer 70 to a downstream power amplifier. If for pure coincidence the predistorted vector D has opposed direction and equal module in respect of the distortion, the maximal cancellation is achieved by effect of the -45 dB predistortion. Without the punctual knowledge of the phase/amplitude signature characterizing the power amplifier distorting behaviour, the best case is generally a chance.

The following **Table 1** reports the component values for a prototype of the invention in a limited bandwidth configuration. The circuit is realized on FR4 substrate, 0.3 mm thick and 55 mm long. Signal frequency is 2.6 GHz. Total loss of the circuit is 14 dB. Input network consists of a Wilkinson divider and a phase shifter made with a delay line; FETs polarization uses quarter-lambda lines.

**TABLE 1 - COMPONENT DATA SHEET**

| Common components | | Stage 72 | | Stage 73 | | Stage 74 | |
|---|---|---|---|---|---|---|---|
| R76 | 0 Ω | R72-2 | 50 Ω | R73-2 | 50 Ω | | |
| R77 | 50 Ω | R72-4 | 4.7 kΩ | R73-4 | 4.7 kΩ | R74-4 | 4.7 kΩ |
| R79 | 4.7 kΩ | R72-7 | 3.3 kΩ | R73-7 | 3.3 kΩ | R74-7 | 100 Ω |
| R80 | 270 Ω | R72-8 | 100 kΩ | R73-8 | 100 kΩ | R74-8 | 100 kΩ |
| R81 | 50 Ω | R72-9 | 330 Ω | R73-9 | 330 Ω | R74-9 | 3.3 kΩ |
| | | R72-10 | 6.8 kΩ | R73-10 | 6.8 kΩ | R74-10 | 6.8 kΩ |
| | | R72-11 | 100 kΩ | R73-11 | 100 kΩ | R74-11 | 100 kΩ |
| | | C72-3 | 18 pF | C73-3 | 18 pF | C74-3 | 18 pF |
| | | C72-5 | 18 pF | C73-5 | 18 pF | C74-5 | 18 pF |
| | | C72-12 | 100 nF | C72-12 | 100 nF | C74-12 | 100 nF |
| | | OP72-6 | Lmc6482 | OP73-6 | Lmc6482 | OP74-6 | Lmc6482 |
| | | FET72-1 | Mfg1908 | FET73-1 | Mfg1908 | FET74-1 | Mfg1908 |

## Claims

1. Analog predistortion linearizer (70) to be connected upstream from a power amplifier (PTX) affected with AM/AM and AM/PM distortions at high power levels of the input signal, comprising amplitude and phase predistortion means arranged so as to impress amplitude and phase distortions on the input signal opposed to the corresponding amplitude and phase distortions introduced by said power amplifier, including:
- a first FET (73-1) subpolarized near pinch-off for amplifying the input signal with variable gain obtaining a first amplitude predistorted signal for compensating said AM/AM distortion;
- first biasing means (73-6, 73-7, 73-8, 73-9, 73-10, 73-11, 73-12, 73-4) of said first FET (73-1) arranged in feedback to set a first constant average drain current in correspondence of which a first predetermined power level of the in-band intermodulation products is generated;
- linear power amplifying means of the input signal (74);
- analog adder means (75) having at least two adding inputs respectively for said first amplitude predistorted signal and the linearly amplified input signal,
**characterized in that** further including:
- a second FET (72-1) subpolarized near pinch-off for amplifying the input signal with variable gain obtaining a second amplitude predistorted signal for compensating said AM/PM distortion;
- second biasing means (72-6, 72-7, 72-8, 72-9, 72-10, 72-11, 72-12, 72-4) of said second FET (72-1) arranged in feedback to set a second constant average drain current in correspondence of which a second predetermined power level of the in-band intermodulation products is generated;
- coupling means (71) arranged for coupling the input signal in phase to both said first FET (73-1) and said linear power amplifying means (74), and 90° out of phase to said second FET (72-1);
- said analog adder means (75) having a third input for summing up said second amplitude predistorted input signal obtaining the desired amplitude and phase predistortion signal.

2. The analog predistortion linearizer of claim 1, **characterized in that** includes a resistive attenuator (78) placed upstream from the input of said linear power amplifying means (74).

3. The analog predistortion linearizer of claim 1 or 2, **characterized in that** said linear power amplifying means (74) includes a third FET (74-1) and relevant third biasing means (74-6, 74-7, 74-8, 74-9, 74-10, 74-11, 74-12, 74-4) arranged in feedback to set a third constant average drain current suitable for class A amplification.

4. The analog predistortion linearizer of claim 3, **characterized in that** said feedback biasing means each includes an operational amplifier (72-6, 73-6, 74-6) arranged as differential integrator of a voltage proportional to the drain current compared to a respective voltage threshold (Vref-P, Vref-G, Vref-L) in order to obtain a biasing voltage for the gate of the FET (72-1, 73-1, 74-1).

5. The analog predistortion linearizer of claim 4, **characterized in that** each operational amplifier is connected to a resistive voltage divider (72-9, 72-10; 73-9, 73-10; 74-9, 74-10) for obtaining said voltage threshold (Vref-P, Vref-G, Vref-L).

6. The analog predistortion linearizer of claim 3 or 4, **characterized in that** said FETs (72-1, 73-1, 74-1) have a cut-off frequency much higher than the currently used frequency range.

7. The analog predistortion linearizer of any claim 1 or 6, **characterized in that** said coupling means (71) includes a hybrid coupler.

8. The analog predistortion linearizer of any claim 1 or 6, **characterized in that** said coupling means (71) includes a Wilkinson splitter coupled to a lambda quarter delay line.

## Patentansprüche

1. Analoger Vorverzerrungs-Linearisierer (70) zur Verbindung signalaufwärts eines Leistungsverstärkers (PTX), der bei hohen Leistungspegeln des Eingangssignals von AM/AM- und AM/PM-Verzerrungen betroffen ist, umfassend Amplituden- und Phasenvorverzerrungsmittel, die dafür ausgelegt sind, dem Eingangssignal Amplituden- und Phasenvorverzerrungen aufzuerlegen, die den entsprechenden durch den Leistungsverstärker eingeführten Amplituden- und Phasenvorverzerrungen entgegengesetzt sind, aufweisend:
- einen ersten FET (73-1), der in der Nähe der Abschnürung subpolarisiert ist, zum Verstärken des Eingangssignals mit variabler Verstärkung zum Erhalten eines ersten amplitudenvorverzerrten Signals zur Kompensation der AM/AM-Verzerrungen;
- erste Vorspannungsmittel (73-6, 73-7, 73-8, 73-9, 73-10, 73-11, 73-12, 73-4) des ersten FET (73-1) in Rückkopplungsanordnung, um einen ersten konstanten mittleren Drainstrom einzustellen, in dessen Entsprechung ein erster vorbestimmter Leistungspegel der Inband-Intermodulationsprodukte erzeugt wird;
- lineare Leistungsverstärkungsmittel des Eingangssignals (74);
- analoge Addierermittel (75) mit mindestens zwei Addiereingängen für das erste amplitudenvorverzerrte Signal bzw. das linear verstärkte Eingangssignal,
**gekennzeichnet durch** ferner
- einen zweiten FET (72-1), der in der Nähe der Abschnürung subpolarisiert ist, zum Verstärken des Eingangssignals mit variabler Verstärkung zum Erhalten eines zweiten amplitudenvorverzerrten Signals zur Kompensation der AM/PM-Verzerrungen;
- zweite Vorspannungsmittel (72-6, 72-7, 72-8, 72-9, 72-10, 72-11, 72-12, 72-4) des zweiten FET (72-1) in Rückkopplungsanordnung, um einen zweiten konstanten mittleren Drainstrom einzustellen, in dessen Entsprechung ein zweiter vorbestimmter Leistungspegel der Inband-Intermodulationsprodukte erzeugt wird;
- Koppelmittel (71), die dafür ausgelegt sind, das Eingangssignal phasengleich sowohl mit dem ersten FET (73-1) als auch den linearen Leistungsverstärkungsmitteln (74) und um 90° phasenverschoben mit dem zweiten FET (72-1) zu koppeln;
- wobei die analogen Addierermittel (75) einen dritten Eingang zum Aufsummieren des zweiten amplitudenvorverzerrten Eingangssignals aufweisen, um das gewünschte Amplituden- und Phasenvorverzerrungssignal zu erhalten.

2. Analoger Vorverzerrungs-Linearisierer nach Anspruch 1, **dadurch gekennzeichnet, dass** er ein Widerstands-Dämpfungsglied (78) aufweist, das signalaufwärts des Eingangs des Leistungsverstärkermittels (74) angeordnet ist.

3. Analoger Vorverzerrungs-Linearisierer nach Anspruch 1 oder 2, **dadurch gekennzeichnet, dass** die linearen Leistungsverstärkungsmittel (74) einen dritten FET (74-1) und relevante dritte Vorspannungsmittel (74-6, 74-7, 74-8, 74-9, 74-10, 74-11, 74-12, 74-4) in Rückkopplungsanordnung zum Einstellen eines für Klasse-A-Verstärkung geeigneten konstanten mittleren Drainstroms umfassen.

4. Analoger Vorverzerrungs-Linearisierer nach Anspruch 3, **dadurch gekennzeichnet, dass** die Rückkopplungs-Vorspannungsmittel jeweils einen Operationsverstärker (72-6, 73-6, 74-6) enthalten, der als Differenzintegrierer einer Spannung ausgelegt ist, die zu dem Drainstrom im Vergleich zu einer jeweiligen Spannungsschwelle (Vref-P, Vref-G, Vref-L) proprortional ist, um eine Vorspannung für das Gate des FET (72-1, 73-1, 74-1) zu erhalten.

5. Analoger Vorverzerrungs-Linearisierer nach Anspruch 4, **dadurch gekennzeichnet, dass** jeder Operationsverstärker mit einem Widerstands-Spannungsteiler (72-9, 72-10; 73-9, 73-10; 74-9, 74-10) verbunden ist, um die Spannungsschwelle (Vref-P, Vref-G, Vref-L) zu erhalten.

6. Analoger Vorverzerrungs-Linearisierer nach Anspruch 3 oder 4, **dadurch gekennzeichnet, dass** die FET (72-1, 73-1, 74-1) eine Grenzfrequenz aufweisen, die viel höher als der derzeit verwendete Frequenzbereich ist.

7. Analoger Vorverzerrungs-Linearisierer nach einem der Ansprüche 1 oder 6, **dadurch gekennzeichnet, dass** die Koppelmittel (71) einen Gabelkoppler enthalten.

8. Analoger Vorverzerrungs-Linearisierer nach einem der Ansprüche 1 oder 6, **dadurch gekennzeichnet, dass** die Koppelmittel (71) einen Wilkinson-Aufteiler enthalten, der mit einer Viertellambda-Verzögerungsleitung gekoppelt ist.

## Revendications

1. Linéariseur à prédistorsion analogique (70) destiné à être connecté en amont d'un amplificateur de puissance (PTX) affecté de distorsions AM/AM et AM/PM aux niveaux de puissance supérieurs du signal d'entrée, comprenant un moyen de prédistorsion en amplitude et en phase adapté pour imposer au signal d'entrée des distorsions d'amplitude et de phase opposées aux distorsions d'amplitude et de phase correspondantes introduites par ledit amplificateur de puissance, incluant :
- un premier FET (73-1) sous-polarisé près de la tension de pincement pour une amplification à gain variable du signal d'entrée donnant lieu à un premier signal prédistordu en amplitude pour compenser ladite distorsion AM/AM ;
- un premier moyen de polarisation (73-6, 73-7, 73-8, 73-9, 73-10, 73-11, 73-12, 73-4) dudit premier FET (73-1) agencé en rétroaction pour régler un premier courant de drain moyen constant en fonction duquel un premier niveau de puissance prédéterminé des produits d'intermodulation dans la bande est généré ;
- un moyen d'amplification de puissance linéaire du signal d'entrée (74) ;
- un moyen additionneur analogique (75) pourvu d'au moins deux entrées additionneuses pour ledit premier signal prédistordu en amplitude et le signal d'entrée amplifié linéairement, respectivement,
**caractérisé en outre par** :
- un deuxième FET (72-1) sous-polarisé près de la tension de pincement pour une amplification à gain variable du signal d'entrée donnant lieu à un deuxième signal prédistordu en amplitude pour compenser ladite distorsion AM/PM ;
- un deuxième moyen de polarisation (72-6, 72-7, 72-8, 72-9, 72-10, 72-11, 72-12, 72-4) dudit deuxième FET (72-1) agencé en rétroaction pour régler un deuxième courant de drain moyen constant en fonction duquel un deuxième niveau de puissance prédéterminé des produits d'intermodulation dans la bande est généré ;
- un moyen de couplage (71) adapté pour coupler ledit signal d'entrée en phase à la fois audit premier FET (73-1) et audit moyen d'amplification de puissance linéaire (74) et avec un déphasage de 90° audit deuxième FET (72-1) ;
- ledit moyen additionneur analogique (75) étant pourvu d'une troisième entrée pour additionner ledit deuxième signal d'entrée prédistordu en amplitude donnant lieu au signal de prédistorsion en amplitude et en phase voulu.

2. Linéariseur à prédistorsion analogique selon la revendication 1, **caractérisé en ce qu'**il inclut un atténuateur résistif (78) placé en amont de l'entrée dudit moyen d'amplification de puissance linéaire (74).

3. Linéariseur à prédistorsion analogique selon la revendication 1 ou 2, **caractérisé en ce que** ledit moyen d'amplification de puissance linéaire (74) inclut un troisième FET (74-1) et un troisième moyen de polarisation (74-6, 74-7, 74-8, 74-9, 74-10, 74-11, 74-12, 74-4) correspondant agencé en rétroaction pour régler un troisième courant de drain moyen constant approprié pour une amplification de classe A.

4. Linéariseur à prédistorsion analogique selon la revendication 3, **caractérisé en ce que** lesdits moyens de polarisation de rétroaction incluent chacun un amplificateur opérationnel (72-6, 73-6, 74-6) agencé en tant qu'intégrateur différentiel d'une tension proportionnelle au courant de drain comparée à un seuil de tension respectif (Vref-P, Vref-G, Vref-L) afin d'obtenir une tension de polarisation pour la grille du FET (72-1, 73-1, 74-1).

5. Linéariseur à prédistorsion analogique selon la revendication 4, **caractérisé en ce que** chaque amplificateur opérationnel est connecté à un diviseur de tension résistif (72-9, 72-10; 73-9, 73-10; 74-9, 74-10) pour obtenir ledit seuil de tension (Vref-P, Vref-G, Vref-L).

6. Linéariseur à prédistorsion analogique selon la revendication 3 ou 4, **caractérisé en ce que** lesdits FET (72-1, 73-1, 74-1) ont une fréquence de coupure beaucoup plus élevée que la gamme de fréquences présentement utilisée.

7. Linéariseur à prédistorsion analogique selon l'une des revendications 1 ou 6, **caractérisé en ce que** ledit moyen de couplage (71) inclut un coupleur hybride.

8. Linéariseur à prédistorsion analogique selon l'une des revendications 1 ou 6, **caractérisé en ce que** ledit moyen de couplage (71) inclut un diviseur de Wilkinson couplé à une ligne à retard quart lambda.
